# EUROPEAN PATENT SPECIFICATION

(11) **EP 3 098 970 B1**
(45) Date of publication and mention of the grant of the patent: **13.05.2020**
(21) Application number: 14883364.3
(22) Date of filing: 20.02.2014
(51) Int. Cl.: H03M 13/00, H03M 13/13, H04L 1/08, H04L 1/18

(54) **CODING RATE MATCHING PROCESSING METHOD AND DEVICE**
VERFAHREN UND VORRICHTUNG ZUR CODIERUNGSRATENANPASSUNGSVERARBEITUNG
PROCÉDÉ ET DISPOSITIF DE TRAITEMENT D'ADAPTATION DE DÉBIT DE CODAGE

(43) Date of publication of application: 30.11.2016
(73) Proprietor: Huawei Technologies Co., Ltd., Longgang District Shenzhen, Guangdong 518129 (CN)
(72) Inventor: CHEN, Jun, Shenzhen Guangdong 518129 (CN); LI, Bin, Shenzhen Guangdong 518129 (CN); SHEN, Hui, Shenzhen Guangdong 518129 (CN)
(74) Representative: Maiwald Patent- und Rechtsanwaltsgesellschaft mbH
(86) International application number: PCT/CN2014/072315
(87) International publication number: WO 2015/123842

(56) References cited:
- EP-A2- 2 262 144
- WO-A1-2013/135022
- CN-A- 101 499 805
- CN-A- 102 075 285
- CN-A- 103 368 583
- CN-A- 103 516 476
- US-A1- 2007 030 917
- US-A1- 2009 052 473
- US-A1- 2010 058 136

## Description

### TECHNICAL FIELD

Embodiments of the present invention relate to communications technologies, and in particular, to a rate matching processing method and apparatus for coding.

### BACKGROUND

At present, a basic principle of Polar code is to determine a row vector (or column vector) of a coding matrix according to a particular condition by using a Bhattacharyya parameter or a capacity (symmetric capacity), or to determine a row vector (or column vector) of a corresponding coding matrix by using a bit error rate. In this way, the Polar code can obtain better performance, for example: a better bit error rate or transmission rate, by using the row vector (or column vector) of the coding matrix selected in the foregoing manner. WO 2013/135022 A1 describes methods and devices for data based on finite length circular buffer rate matching
US 2007/030917 A1 describes methods and devices for channel coding for communication systems.
EP 2 262 144 A2 describes (Quasi-Complementary Turbo Code) generating methods and devices.

In addition, the Polar code may further support a hybrid automatic repeat request (Hybrid Automatic Repeat Request; HARQ for short) function by using a two-step rate matching algorithm. Specifically, a specific implementation manner of rate matching processing of the Polar code is: dividing coded bits output by a Polar encoder into three groups, and performing an independent and uniform puncturing operation or repetition operation on each group, so that a length of a coded bit can be matched to a size of a virtual incremental redundancy buffer (Incremental Redundancy buffer; IR buffer for short) and a size of a transmission resource.

However, when the two-step rate matching algorithm is used, coded bits output by a Polar encoder need to be divided into three groups, which therefore conflicts with selection of a row vector (or column vector) of a coding matrix of Polar code. That is, in a case in which an arrangement order and an output order of priority bits are not considered, a row vector (or column vector) of a coding matrix cannot be selected in the foregoing manner, and consequently a loss in a performance gain occurs during decoding, causing severe decoding error transmission, and further causing a problem of poor performance of the Polar code.

### SUMMARY

Embodiments of the present invention provide a rate matching processing method and apparatus for coding as defined by the independent claims, so as to overcome a problem in the prior art that use of a two-step rate matching algorithm may conflict with selection of a row vector (or column vector) of a coding matrix of Polar code, which leads to a loss in a performance gain during decoding, causing severe decoding error transmission, and further causing poor performance of the Polar code. Further embodiments are provided by the dependent claims

A first aspect of the embodiments of the present invention provides a rate matching processing method according to claim 1.

Possible implementations of the first aspect are provided in claims 2 to 6.

A second aspect of the embodiments of the present invention provides a rate matching processing apparatus according to claim 7. Possible implementations of the second aspect are provided in claims 8 to 11.

According to the rate matching processing method and apparatus for coding in the embodiments of the present invention, coded bits output by a Polar encoder are divided into M groups, and interleaving processing is performed on coded bits in the 1^{st} group to the M^{th} group separately; bit reduction processing is performed on coded bits in multiple groups of the *M* groups according to a size of a virtual IR buffer module, bits, on which the reduction processing is performed, in first groups of the 1^{st} group to the M^{th} group are coded and output to the virtual IR buffer module, and coded bits in last groups of the 1^{st} group to the *M*^{th} group are discarded; a quantity of available bits of a transmission channel is compared with a quantity of coded bits, in multiple groups, stored in the virtual IR buffer module, and repetition or reduction processing is performed, according to a comparison result, on the coded bits, in the multiple groups, stored in the virtual IR buffer module; and concatenation processing is performed on coded bits on which the repetition or reduction processing is performed, to generate one bit stream, and the bit stream is sent through the transmission channel. Because coded bits output by a Polar encoder are randomly divided into multiple groups, and bit reduction processing or bit reduction processing and bit repetition processing are performed on the multiple groups continuously, not only an efficient and flexible rate matching technology can be supported, but also HARQ retransmission can be supported, and transmission efficiency can be further improved.

### BRIEF DESCRIPTION OF DRAWINGS

To describe the technical solutions in the embodiments of the present invention or in the prior art more clearly, the following briefly introduces the accompanying drawings required for describing the embodiments or the prior art. Apparently, the accompanying drawings in the following description show some embodiments of the present invention, and persons of ordinary skill in the art may still derive other drawings from these accompanying drawings without creative efforts.
FIG. 1 is a flowchart of an embodiment of a rate matching processing method for coding according to the present invention;
FIG. 2 is a flowchart of another embodiment of a rate matching processing method for coding according to the present invention;
FIG. 3 is a flowchart of still another embodiment of a rate matching processing method for coding according to the present invention;
FIG. 4 is a flowchart of yet another embodiment of a rate matching processing method for coding according to the present invention;
FIG. 5 is a schematic structural diagram of an embodiment of a rate matching processing apparatus for coding according to the present invention; and
FIG. 6 is a schematic structural diagram of another embodiment of a rate matching processing apparatus for coding according to the present invention.

### DESCRIPTION OF EMBODIMENTS

To make the objectives, technical solutions, and advantages of the embodiments of the present invention clearer, the following clearly and completely describes the technical solutions in the embodiments of the present invention with reference to the accompanying drawings in the embodiments of the present invention. Apparently, the described embodiments are some but not all of the embodiments of the present invention. All other embodiments obtained by persons of ordinary skill in the art based on the embodiments of the present invention without creative efforts shall fall within the protection scope of the present invention.

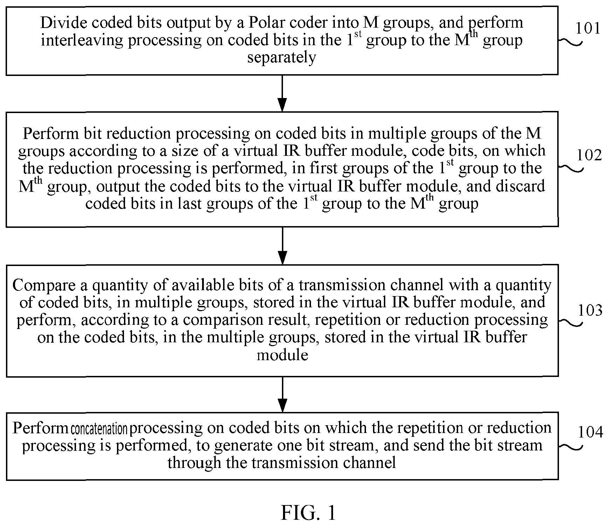

FIG. 1 is a flowchart of an embodiment of a rate matching processing method for coding according to the present invention. As shown in FIG. 1, the method in this embodiment may include:
Step 101: Divide coded bits output by a Polar encoder into M groups, and perform interleaving processing on coded bits in the 1st group to the Mth group separately.

In this embodiment, coded bits output by the Polar encoder may be systematic Polar coded bits or non-systematic Polar coded bits.

Step 102: Perform bit reduction processing on coded bits in multiple groups of the *M* groups according to a size of a virtual IR buffer module, code bits, on which the reduction processing is performed, in first groups of the 1^{st} group to the *M*^{th} group, output the coded bits to the virtual IR buffer module, and discard coded bits in last groups of the 1^{st} group to the *M*^{th} group.

Step 103: Compare a quantity of available bits of a transmission channel with a quantity of coded bits, in multiple groups, stored in the virtual IR buffer module, and perform, according to a comparison result, repetition or reduction processing on the coded bits, in the multiple groups, stored in the virtual IR buffer module.

In this embodiment, a quantity of available bits of a transmission channel is a quantity of available resources of a physical layer air interface.

In this embodiment, if the quantity of the coded bits, in the multiple groups, stored in the virtual IR buffer module is greater than or equal to the quantity of available bits of the transmission channel, bit reduction processing is performed, that is, first coded bits of a group corresponding to a selected start position are output preferentially, and rest coded bits are discarded. In addition, if the quantity of the coded bits, in the multiple groups, stored in the virtual IR buffer module is less than the quantity of available bits of the transmission channel, bit repetition processing is performed, and starting from the group corresponding to the selected start position, coded bits of groups are output cyclically and repeatedly, first coded bits of the groups are output preferentially, and last coded bits are discarded.

The selected start position may be pre-defined, or is a Hybrid Automatic Repeat Request, HARQ for short, Redundancy Version; RV for short) indication sent by a wireless communications system.

Step 104: Perform concatenation processing on coded bits on which the repetition or reduction processing is performed, to generate one bit stream, and send the bit stream through the transmission channel.

In this embodiment, coded bits output by a Polar encoder are divided into M groups, and interleaving processing is performed on coded bits in the 1^{st} group to the M^{th} group separately; bit reduction processing is performed on coded bits in multiple groups of the *M* groups according to a size of a virtual IR buffer module, bits, on which the reduction processing is performed, in first groups of the 1^{st} group to the M^{th} group are coded and output to the virtual IR buffer module, and coded bits in last groups of the 1^{st} group to the *M*^{th} group are discarded; a quantity of available bits of a transmission channel is compared with a quantity of coded bits, in multiple groups, stored in the virtual IR buffer module, and repetition or reduction processing is performed, according to a comparison result, on the coded bits, in the multiple groups, stored in the virtual IR buffer module; and concatenation processing is performed on coded bits on which the repetition or reduction processing is performed, to generate one bit stream, and the bit stream is output through the transmission channel. Because coded bits output by a Polar encoder are randomly divided into multiple groups, and bit reduction processing or bit reduction processing and bit repetition processing are performed on the multiple groups continuously, not only an efficient and flexible rate matching technology can be supported, but also HARQ retransmission can be supported, and transmission efficiency can be further improved.

The technical solution in the method embodiment shown in FIG. 1 is described in detail below by using several specific embodiments.

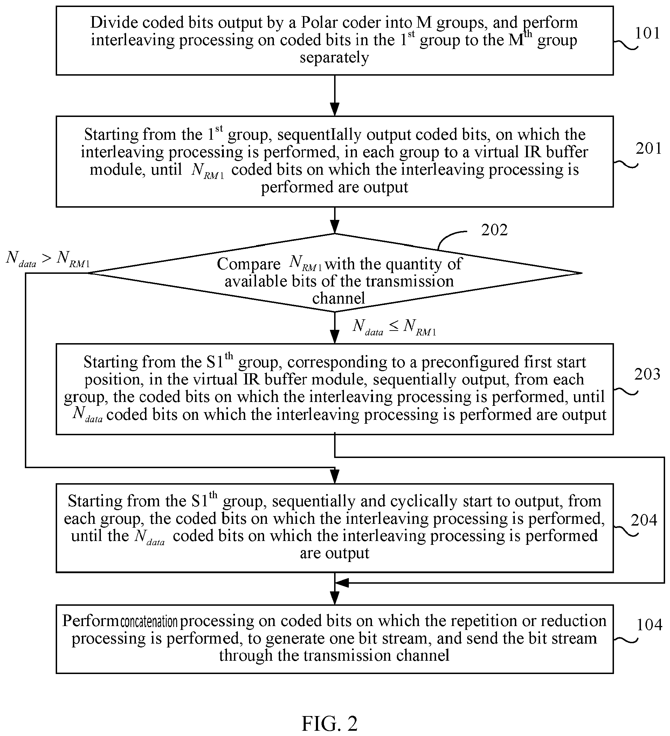

FIG. 2 is a flowchart of another embodiment of a rate matching processing method for coding according to the present invention. On a basis of the foregoing embodiment shown in FIG. 1, as shown in FIG. 2, in this embodiment, an example in which coded bits output by a Polar encoder may be non-systematic Polar coded bits is used, that is, the i ^{th} group includes P coded bits *j*=(*i-*1)*P*+*t*, where *i*=1,2,···,*M*, *t*=0,1,···,*P*-1, and *P* = *N* / *M*; *N* is a positive integer and represents a length of a coded bit output by the Polar encoder. The technical solution in this embodiment is described in detail, and a specific implementation manner of step 102 is:

Step 201: Starting from the 1^{st} group, sequentially output coded bits, on which the interleaving processing is performed, in each group to the virtual IR buffer module, until *N*_{*RM*1} coded bits on which the interleaving processing is performed are output, where *N*_{*RM*1} = min(*N*,*N_{IR}*), and *N_{IR}* represents the size of the virtual IR buffer module.

Optionally, a specific implementation manner of step 103 is:

Step 202: Compare *N*_{*RM*1} with the quantity of available bits of the transmission channel. If *N_{data}* ≤ *N*_{*RM*1}, perform step 203; if *N_{data}* > *N*_{*RM*1}, perform step 204.

Step 203: Starting from the S1^{th} group, corresponding to a preconfigured first start position, in the virtual IR buffer module, sequentially output, from each group, the coded bits on which the interleaving processing is performed, until *N_{data}* coded bits on which the interleaving processing is performed are output.

Step 204: Starting from the S1^{th} group, sequentially and cyclically start to output, from each group, the coded bits on which the interleaving processing is performed, until the *N_{data}* coded bits on which the interleaving processing is performed are output, where *N_{data}* represents the quantity of available bits of the transmission channel.

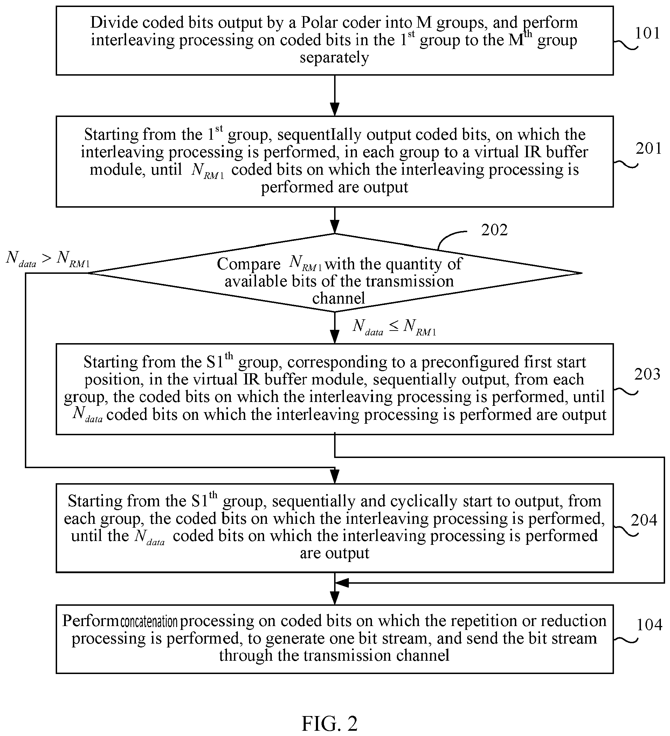

FIG. 3 is a flowchart of still another embodiment of a rate matching processing method for coding according to the present invention. On a basis of the foregoing embodiment shown in FIG. 1, as shown in FIG. 3, in this embodiment, an example in which coded bits output by a Polar encoder may be non-systematic Polar coded bits is used, that is, the i^{th} group includes P coded bits *j*=(*i-*1)*P*+*t*, where *i*=1,2,···,*M*, *t*=0,1,···*,P*-1, and *P* = *N*/*M*; *N* is a positive integer and represents a length of a coded bit output by the Polar encoder. The technical solution in this embodiment is described in detail, and another specific implementation manner of step 102 is:

Step 301: Sequentially output coded bits, on which the interleaving processing is performed, in the 1^{st} group to the W^{th} group to the virtual IR buffer module, and output the 1^{st} to the *N*_{*RM*1}*-WP*^{th} coded bits, on which the interleaving processing is performed, in the (W+1)^{th} group to the virtual IR buffer module.

W meets *WP<N*_{*RM*1} ≤(*W*+1)*P*, *N*_{*RM*1}=min(*N*,*N_{IR}*), and *N_{IR}* represents the size of the virtual IR buffer module.

Optionally, another specific implementation manner of step 103 is:

Step 302: Compare *N*_{*RM*1} with the quantity of available bits of the transmission channel. If *N_{data}* ≤ *N*_{*RM*1}, perform step 303; if *N_{data}* > *N*_{*RM*1}, perform step 304.

Step 303: Starting from the S2^{th} group, corresponding to a preconfigured second start position, in the virtual IR buffer module, sequentially output coded bits, on which the interleaving processing is performed, in V groups, and output the 1^{st} to the *N_{data} -VPₜₕ* coded bits, on which interleaving coding processing is performed, in a next group after the V groups.

V meets *VP*<*N_{data}≤*(*V*+1)*P*; and *N*_{data} represents the quantity of available bits of the transmission channel.

Step 304: Starting from the S2^{th} group, sequentially and cyclically output coded bits on which the interleaving processing is performed, in W+1 groups, where a quantity of cycles is *W*'; and then starting from the S2^{th} group again, sequentially output the 1^{st} to the *N_{data}*- *W'N*_{*RM*1}^{th} coded bits, on which the interleaving processing is performed, in each group of *V*'+1 groups. *W*' meets *W'P*<*N*_{data}≤(*W'*+1)*N*_{*RM*1}, *V*' meets *V*'*P*<*N_{data}-W'NN*_{*RM*1}≤(*V'*+1)*P*, and *N*_{data} represents the quantity of available bits of the transmission channel.

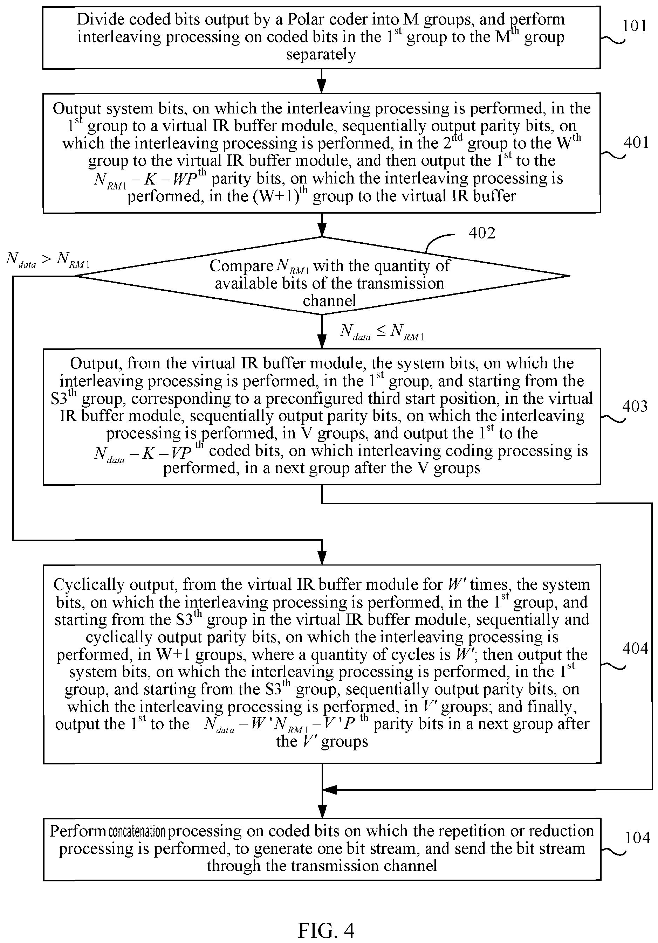

FIG. 4 is a flowchart of a rate matching processing method related to the present invention. On a basis of the foregoing embodiment shown in FIG. 1, as shown in FIG. 4, in this embodiment, an example in which coded bits output by a Polar encoder may be systematic Polar coded bits is used, that is, the 1^{st} group includes system bits, the 2^{nd} group to the M^{th} group include parity bits, the i ^{th} group P parity bits includes *j*=(*i-*1)*P*+*t*, where *i*=1,2,···,*M*-1, *t*=0,1,···,*P-*1, and *P*=(*N-K*)/(*M-*1); *N* is a positive integer and represents a length of a coded bit output by the Polar encoder; *K* represents the foremost *K* bits of the coded bits output by the Polar encoder. The technical solution in this embodiment is described in detail, and still another specific implementation manner of step 102 is:

Step 401: Output system bits, on which the interleaving processing is performed, in the 1^{st} group to the virtual IR buffer module; sequentially output parity bits, on which the interleaving processing is performed, in the 2^{nd} group to the W^{th} group to the virtual IR buffer module; and then output the 1^{st} to the *N*_{*RM*1} -*K* - *WP*ₜₕ parity bits, on which the interleaving processing is performed, in the (W+1)^{th} group to the virtual IR buffer; where W meets *WP*<*N*_{*RM*1}*-K*≤(*W*+1)*P*, *N*_{*RM*1} =min(*N*,*N_{IR}*), and *N_{IR}* represents the size of the virtual IR buffer.

Optionally, still another specific implementation manner of step 103 is:

Step 402: Compare *N*_{*RM*1} with the quantity of available bits of the transmission channel. If *N_{data}* ≤ *N*_{*RM*1}, perform step 403; if *N_{data}* > *N*_{*RM*1}, perform step 404.

Step 403: Output, from the virtual IR buffer module, the system bits, on which the interleaving processing is performed, in the 1^{st} group; and starting from the S3^{th} group, corresponding to a preconfigured third start position, in the virtual IR buffer module, sequentially output parity bits, on which the interleaving processing is performed, in V groups, and output the 1^{st} to the *N_{data}* - *K* - *VP*ₜₕ coded bits, on which interleaving coding processing is performed, in a next group after the V groups, where V meets *VP*<*N_{data}-K*≤(*V*+1)*P*, and *N_{data}* represents the quantity of available bits of the transmission channel.

Step 404: Cyclically output, from the virtual IR buffer module for *W*' times, the system bits, on which the interleaving processing is performed, in the 1^{st} group; starting from the S3^{th} group in the virtual IR buffer module, sequentially and cyclically output parity bits, on which the interleaving processing is performed, in W+1 groups, where a quantity of cycles is *W*'; then output the system bits, on which the interleaving processing is performed, in the 1^{st} group, and starting from the S3^{th} group, sequentially output parity bits, on which the interleaving processing is performed, in *V*' groups; and finally, output the 1^{st} to the *N_{data}*-*W*'*N*_{*RM*1}-*V*'*P*ₜₕ parity bits in a next group after the *V*' groups; where *W*' meets *W'P*<*N_{data}*≤(*W'*+1)*N*_{*RM*1}, *V'* meets *V'P*<*N_{data}-W'NN*_{*RM*1}≤(*V*'+1)*P*, and *N_{data}* represents the quantity of available bits of the transmission channel.

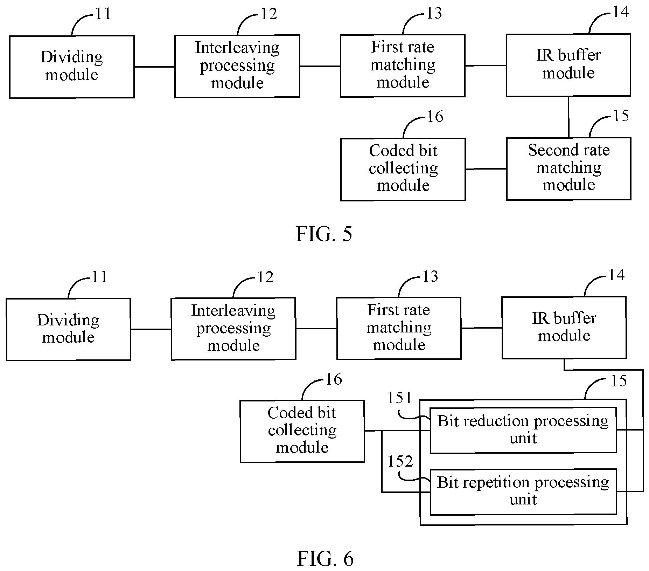

FIG. 5 is a schematic structural diagram of an embodiment of a rate matching processing apparatus for coding according to the present invention. As shown in FIG. 5, the apparatus of this embodiment may include: a dividing module 11, an interleaving processing module 12, a first rate matching module 13, an IR buffer module 14, a second rate matching module 15, and a coded bit collecting module 16, where the dividing module 11 is configured to divide coded bits output by a Polar encoder into M groups, where *M* is a positive integer; the interleaving processing module 12 is configured to perform interleaving processing on coded bits in the 1^{st} group to the *M*^{th} group separately; the first rate matching module 13 is configured to perform bit reduction processing on coded bits in multiple groups of the *M* groups according to a size of the virtual IR buffer module 14, code bits, on which the reduction processing is performed, in first groups of the 1^{st} group to the M^{th} group, output the coded bits to the virtual IR buffer module 14, discard coded bits in last groups of the 1^{st} group to the *M*^{th} group, and discard the coded bits of the last groups; the IR buffer module 14 is configured to store coded bits, in multiple groups, output by the first rate matching module; the second rate matching module 15 is configured to compare a quantity of available bits of a transmission channel with a quantity of coded bits, in multiple groups, stored in the virtual IR buffer module, and perform, according to a comparison result, repetition or reduction processing on the coded bits, in the multiple groups, stored in the virtual IR buffer module 14; and the coded bit collecting module 16 is configured to perform concatenation processing on coded bits on which the repetition or reduction processing is performed, to generate one bit stream, and send the bit stream through the transmission channel.

The apparatus in this embodiment may be configured to execute the technical solution in the method embodiment shown in FIG. 1. Implementation principles and technical effects of this embodiment and the method embodiment are similar, and details are not described herein again.

FIG. 6 is a schematic structural diagram of another embodiment of a rate matching processing apparatus for coding according to the present invention. As shown in FIG. 6, on a basis of the apparatus structure shown in FIG. 5, in the apparatus in this embodiment, when the i^{th} group includes P coded bits *j*=(*i*-1)*P*+*t*, where *i*=1,2,···,*M*, *t*=0,1,···,*P*-1, and *P* = *N* / *M*, *N* is a positive integer, and *N* represents a length of a coded bit output by the Polar encoder, the first rate matching module 13 is specifically configured to: starting from the 1^{st} group, sequentially output coded bits, on which the interleaving processing is performed, in each group to the virtual IR buffer module 14, until *N*_{*RM*1} coded bits on which the interleaving processing is performed are output, where *N*_{*RM*1} =min(*N*,*N_{IR}*), and *N_{IR}* represents the size of the virtual IR buffer module 14.

Optionally, the second rate matching module 15 includes: a bit reduction processing unit 151 and a bit repetition processing unit 152, where the bit reduction processing unit 151 is configured to: when *N_{data}* ≤ *N*_{*RM*1}, starting from the S1^{th} group, corresponding to a preconfigured first start position, in the virtual IR buffer module, sequentially output, from each group, the coded bits on which the interleaving processing is performed, until *N_{data}* coded bits on which the interleaving processing is performed are output; and the bit repetition processing unit 152 is configured to: when *N_{data}* > *N*_{*RM*1}, starting from the S1^{th} group, sequentially and cyclically start to output, from each group, the coded bits on which the interleaving processing is performed, until the *N_{data}* coded bits on which the interleaving processing is performed are output, where *N_{data}* represents the quantity of available bits of the transmission channel.

The apparatus in this embodiment may be configured to execute the technical solution in the method embodiment shown in FIG. 2. Implementation principles and technical effects of this embodiment and the method embodiment are similar, and details are not described herein again.

Further, in still another embodiment of the present invention, on a basis of the foregoing embodiment shown in FIG. 5, when the i^{th} group includes P coded bits *j*=(*i*-1)*P*+*t*, where *i*=1,2,···,*M*, *t* =0,1,···,*P*-1, and *P = N* / *M* , *N* is a positive integer, and *N* represents a length of a coded bit output by the Polar encoder, the first rate matching module 13 is specifically configured to: sequentially output coded bits, on which the interleaving processing is performed, in the 1^{st} group to the W^{th} group to the virtual IR buffer module 14, and output the 1^{st} to the *N*_{*RM*1}*-WP*^{th} coded bits, on which the interleaving processing is performed, in the (W+1)^{th} group to the virtual IR buffer module 14, where W meets *WP < N*_{*RM*1} ≤ (*W* + 1)*P*, *N*_{*RM*1} = min (*N*, *N_{IR}*), and *N_{IR}* represents the size of the virtual IR buffer module 14.

Optionally, the second rate matching module 15 includes: a bit reduction processing unit and a bit repetition processing unit, where the bit reduction processing unit is configured to: when *N_{data}* ≤ *N*_{*RM*1}, starting from the S2^{th} group, corresponding to a preconfigured second start position, in the virtual IR buffer module 14, sequentially output coded bits, on which the interleaving processing is performed, in V groups, and output the 1^{st} to the *N_{data}*-*VP*ₜₕ coded bits, on which interleaving coding processing is performed, in a next group after the V groups, where V meets *VP*<*N_{data}≤*(*V*+1*)P*; and *N*_{data} represents the quantity of available bits of the transmission channel; and the bit repetition processing unit is configured to: when *N_{data}* > *N*_{*RM*1}, starting from the S2^{th} group, sequentially and cyclically output coded bits, on which the interleaving processing is performed, in W+1 groups, where a quantity of cycles is *W*'; and then starting from the S2^{th} group again, sequentially output the 1^{st} to the *N_{data}* - *W'N*_{*RM*1^{th}} coded bits, on which the interleaving processing is performed, in each group of *V*'+1 groups; where *W*' meets *W'P*<*N_{data}*≤(*W'*+1)*N*_{*RM*1}, *V*' meets *V'P*<*N_{data}-W'NN*_{*RM*1}≤(*V'*+1)*P*, and *N*_{data} represents the quantity of available bits of the transmission channel.

The apparatus in this embodiment may be configured to execute the technical solution in the method embodiment shown in FIG. 3. Implementation principles and technical effects of this embodiment and the method embodiment are similar, and details are not described herein again.

Further, in an apparatus related to the foregoing embodiment shown in FIG. 5, when the 1^{st} group includes system bits, the 2^{nd} group to the M^{th} group include parity bits, the i^{th} group includes P parity bits *j*=(*i*-1)*P*+*t*, where *i*=1,2,···*,M*-1, *t*=0,1,···,*P*-1, and *P*=(*N*-*K*)/(*M*-1), *N* is a positive integer and represents a length of a coded bit output by the Polar encoder, and *K* represents the foremost *K* bits of the coded bits output by the Polar encoder, the first rate matching module 13 is specifically configured to output system bits, on which the interleaving processing is performed, in the 1^{st} group to the virtual IR buffer module 14, sequentially output parity bits, on which the interleaving processing is performed, in the 2^{nd} group to the W^{th} group to the virtual IR buffer module 14, and then output the 1^{st} to the *N*_{*RM*1} - *K* - *WP*ₜₕ parity bits, on which the interleaving processing is performed, in the (W+1)^{th} group to the virtual IR buffer module 14, where W meets *WP*<*N*_{*RM*1}*-K≤*(*W*+1)*P*, *N*_{*RM*1}=min(*N*,*N_{IR}*), and *N*_{IR} represents the size of the virtual IR buffer module 14.

Optionally, the second rate matching module 15 in the said apparatus related to the embodiment shown in Fig. 5 includes: a bit reduction processing unit and a bit repetition processing unit, where the bit reduction processing unit is configured to: when *N_{data}* ≤ *N*_{*RM*1}, output, from the virtual IR buffer module, the system bits, on which the interleaving processing is performed, in the 1^{st} group, and starting from the S3^{th} group, corresponding to a preconfigured third start position, in the IR buffer, sequentially output parity bits, on which the interleaving processing is performed, in V groups, and output the 1^{st} to the *N_{data}*-*K*-*VP*ₜₕ coded bits, on which interleaving coding processing is performed, in a next group after the V groups, where V meets *VP*<*N_{data}-K*≤(*V*+1)*P*, and *N_{data}* represents the quantity of available bits of the transmission channel; and the bit repetition processing unit is configured to: when *N_{data}* > *N*_{*RM*1}, cyclically output, from the virtual IR buffer module for *W*' times, the system bits, on which the interleaving processing is performed, in the 1^{st} group, and starting from the S3^{th} group in the virtual IR buffer module, sequentially and cyclically output parity bits, on which the interleaving processing is performed, in W+1 groups, where a quantity of cycles is *W*'; then output the system bits, on which the interleaving processing is performed, in the 1^{st} group, and starting from the S3^{th} group, sequentially output parity bits, on which the interleaving processing is performed, in *V*' groups; and finally, output the 1^{st} to the *N_{data}*-*W'N*_{*RM*1}-*V*'*P*ₜₕ parity bits in a next group after the *V*' groups, where *W*' meets *W'P*< *N_{data}* ≤ (*W'*+1)*N*_{*RM*1}; *V*' meets *V'P*<*N_{data}-W'NN*_{*RM*1} ≤(*V'*+1)*P*; and *N*_{data} represents the quantity of available bits of the transmission channel.

The apparatus in this embodiment may be configured to execute the technical solution in the method embodiment shown in FIG. 4. Implementation principles and technical effects of this embodiment and the method embodiment are similar, and details are not described herein again.

Persons of ordinary skill in the art may understand that all or some of the steps of the method embodiments may be implemented by a program instructing relevant hardware. The program may be stored in a computer-readable storage medium. When the program runs, the steps of the method embodiments are performed. The foregoing storage medium includes: any medium that can store program code, such as a ROM, a RAM, a magnetic disk, or an optical disc.

Finally, it should be noted that the foregoing embodiments are merely intended for describing the technical solutions in the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions in the embodiments of the present invention.

## Claims

1. A rate matching processing method for coding, comprising:
dividing (101) coded bits output by a Polar encoder into *M* groups, and performing interleaving processing on coded bits in the 1^{st} group to the *M*^{th} group separately, wherein *M* is a positive integer;
wherein the method is **characterized by**:
performing (102) bit reduction processing on coded bits having undergone interleaving processing in multiple groups of the *M* groups according to a size of a virtual IR buffer module, outputting the coded bits in first groups of the 1^{st} group to the M^{th} group to the virtual IR buffer module, wherein bit reduction processing is through discarding coded bits in last groups of the 1^{st} group to the *M*^{th} group;
comparing (103) a quantity of available bits of a transmission channel with a quantity of coded bits, in multiple groups, stored in the virtual IR buffer module, and performing, according to a comparison result, repetition or reduction processing on the coded bits, in the multiple groups, stored in the virtual IR buffer module; and
performing (104) concatenation processing on coded bits after repetition or reduction processing is performed, to generate one bit stream, and sending the bit stream through the transmission channel.

2. The method according to claim 1, wherein when the i^{th} group comprises P coded bits *j*=(*i*-1)*P*+*t*, wherein *i*=1, 2,···,*M*, *t* = 0,1,···,*P*-1, and *P* = *N* / *M*, *N* is a positive integer, and *N* represents a length of a coded bit output by the Polar encoder, the performing bit reduction processing on coded bits in multiple groups of the *M* groups according to a size of a virtual IR buffer module, coding bits, on which the reduction processing is performed, in first groups of the 1^{st} group to the M^{th} group, outputting the coded bits to the virtual IR buffer module, and discarding coded bits in last groups of the 1^{st} group to the *M*^{th} group comprises:
starting from the 1^{st} group, sequentially outputting coded bits, on which the interleaving processing is performed, in each group to the virtual IR buffer module, until *N*_{*RM*1} coded bits on which the interleaving processing is performed are output, wherein *N*_{*RM*1} =min(*N*,*N_{IR}*), and *N_{IR}* represents the size of the virtual IR buffer module.

3. The method according to claim 2, wherein the comparing a quantity of available bits of a transmission channel with a quantity of coded bits, in multiple groups, stored in the virtual IR buffer module, and performing, according to a comparison result, repetition or reduction processing on the coded bits, in the multiple groups, stored in the virtual IR buffer module comprises:
when *N_{data}*≤*N*_{*RM*1}, starting from the S1^{th} group, corresponding to a preconfigured first start position, in the virtual IR buffer module, sequentially outputting, from each group, the coded bits on which the interleaving processing is performed, until *N_{data}* coded bits on which the interleaving processing is performed are output; and
when *N_{data}* > *N*_{*RM*1}, starting from the S1^{th} group, sequentially and cyclically starting to output, from each group, the coded bits on which the interleaving processing is performed, until the *N_{data}* coded bits on which the interleaving processing is performed are output, wherein *N_{data}* represents the quantity of available bits of the transmission channel.

4. The method according to claim 1, wherein when the i ^{th} group comprises P coded bits, *j*=(*i*-1)*P*+*t*, wherein *i*=1,2,···,*M*, *t*=0,1,···,*P-*1, and *P* = *N* / *M*, *N* is a positive integer, and *N* represents a length of a coded bit output by the Polar encoder, the performing bit reduction processing on coded bits in multiple groups of the *M* groups according to a size of a virtual IR buffer module, coding bits, on which the reduction processing is performed, in first groups of the 1^{st} group to the M^{th} group, outputting the coded bits to the virtual IR buffer module, and discarding coded bits in last groups of the 1^{st} group to the *M*^{th} group comprises:
sequentially outputting coded bits, on which the interleaving processing is performed, in the 1^{st} group to the W^{th} group to the virtual IR buffer module, and outputting the 1^{st} to the *N*_{*RM*1}*-WP*^{th} coded bits, on which the interleaving processing is performed, in the (W+1)^{th} group to the virtual IR buffer module, wherein W meets *WP*<*N*_{*RM*1} ≤(*W*+1)*P*, *N*_{*RM*1} =min(*N*,*N_{IR}*), and *N_{IR}* represents the size of the virtual IR buffer module.

5. The method according to claim 4, wherein the comparing a quantity of available bits of a transmission channel with a quantity of coded bits, in multiple groups, stored in the virtual IR buffer module, and performing, according to a comparison result, repetition or reduction processing on the coded bits, in the multiple groups, stored in the virtual IR buffer module comprises:
when *N_{data}* ≤ *N*_{*RM*1}, starting from the S2^{th} group, corresponding to a preconfigured second start position, in the virtual IR buffer module, sequentially outputting coded bits, on which the interleaving processing is performed, in V groups, and outputting the 1^{st} to the *N_{data}-VP*^{th} coded bits, on which interleaving coding processing is performed, in a next group after the V groups, wherein V meets *VP*<*N_{data}* ≤(*V*+1)*P*, and *N_{data}* represents the quantity of available bits of the transmission channel; and
when *N_{data}* > *N*_{*RM*1}, starting from the S2^{th} group, sequentially and cyclically outputting coded bits, on which the interleaving processing is performed, in W+1 groups, wherein a quantity of cycles is *W*'; and then starting from the S2^{th} group again, sequentially outputting the 1^{st} to the *N_{data}* - *W' N_{RM1}* ^{th} coded bits, on which the interleaving processing is performed, in each group of *V*'+ 1 groups; wherein *W'* meets *W'P*<*N_{data}*≤(*W'*+1)*N*_{*RM*1}*, V*' meets *V'P* < *N_{data}* -*W'NN*_{*RM*1} ≤(*V'*+1)*P*, and *N_{data}* represents the quantity of available bits of the transmission channel.

6. The method according to claim 1, wherein the comparing a quantity of available bits of a transmission channel with a quantity of coded bits, in multiple groups, stored in the virtual IR buffer module, and performing, according to a comparison result, repetition or reduction processing on the coded bits, in the multiple groups, stored in the virtual IR buffer module comprises:
when *N_{data}* ≤ *N*_{*RM*1}, outputting, from the virtual IR buffer module, the system bits, on which the interleaving processing is performed, in the 1^{st} group; and starting from the S3^{th} group, corresponding to a preconfigured third start position, in the virtual IR buffer module, sequentially outputting parity bits, on which the interleaving processing is performed, in V groups, and outputting the 1^{st} to the *N_{data}* - *K* - *VP*ₜₕ coded bits, on which interleaving coding processing is performed, in a next group after the V groups, wherein V meets *VP*<*N_{data} -K* ≤(*V*+1)*P*, and *N_{data}* represents the quantity of available bits of the transmission channel; and
when *N_{data}* > *N*_{*RM*1}, cyclically outputting, from the virtual IR buffer module for *W*' times, the system bits, on which the interleaving processing is performed, in the 1^{st} group, and starting from the S3^{th} group in the virtual IR buffer module, sequentially and cyclically outputting parity bits, on which the interleaving processing is performed, in W' + 1 groups, wherein a quantity of cycles is *W*'; then outputting the system bits, on which the interleaving processing is performed, in the 1^{st} group, and starting from the S3^{th} group, sequentially outputting parity bits, on which the interleaving processing is performed, in *V*' groups; and finally, outputting the 1^{st} to the *N_{data}* -*W'N*_{*RM*1} - *V*'*P*ₜₕ parity bits in a next group after the *V*' groups, wherein *W*' meets *W'P*<*N_{data}* ≤(*W'*+1)*N*_{*RM*1}; *V'* meets *V'P*<*N_{data} -W'NN*_{*RM*1} ≤(*V'*+1)*P*; and *N_{data}* represents the quantity of available bits of the transmission channel.

7. A rate matching processing apparatus for coding, comprising:
a dividing module (11), configured to divide coded bits output by a Polar encoder into *M* groups, wherein *M* is a positive integer;
an interleaving processing module (12), configured to perform interleaving processing on coded bits in the 1^{st} group to the *M*^{th} group separately;
wherein the apparatus is **characterized by**:
a first rate matching module (13), configured to perform bit reduction processing on coded bits having undergone interleaving processing in multiple groups of the *M* groups according to a size of a virtual IR buffer module (14), output the coded bits in first groups of the 1^{st} group to the M^{th} group to the virtual IR buffer module, wherein bit reduction processing is through discarding coded bits in last groups of the 1^{st} group to the *M*^{th} group;
the IR buffer module, configured to store coded bits, in multiple groups, output by the first rate matching module;
a second rate matching module (15), configured to compare a quantity of available bits of a transmission channel with a quantity of coded bits, in multiple groups, stored in the virtual IR buffer module, and perform, according to a comparison result, repetition or reduction processing on the coded bits, in the multiple groups, stored in the virtual IR buffer module; and
a coded bit collecting module (16), configured to perform concatenation processing on coded bits after repetition or reduction processing is performed, to generate one bit stream.

8. The apparatus according to claim 7, wherein when the i ^{th} group comprises P coded bits, *j*=(*i*-1*)P*+*t*, wherein *i*=1,2,···,*M*, *t* = 0,1,···,*P*-1, and *P* = *N* / *M*, *N* is a positive integer and *N* represents a length of a coded bit output by the Polar encoder, the first rate matching module is specifically configured to: starting from the 1^{st} group, sequentially output coded bits, on which the interleaving processing is performed, in each group to the virtual IR buffer module, until *N*_{*RM*1} coded bits on which the interleaving processing is performed are output, wherein *N*_{*RM*1} =min(*N*,*N_{IR}*), and *N_{IR}* represents the size of the virtual IR buffer module.

9. The apparatus according to claim 8, wherein the second rate matching module comprises:
a bit reduction processing unit, configured to: when *N_{data}* ≤ *N*_{*RM*1}, starting from the S1^{th} group, corresponding to a preconfigured first start position, in the virtual IR buffer module, sequentially output, from each group, the coded bits on which the interleaving processing is performed, until *N_{data}* coded bits on which the interleaving processing is performed are output; and
a bit repetition processing unit, configured to: when *N_{data}* > *N*_{*RM*1}, starting from the S1^{th} group, sequentially and cyclically start to output, from each group, the coded bits on which the interleaving processing is performed, until the *N_{data}* coded bits on which the interleaving processing is performed are output, wherein *N_{data}* represents the quantity of available bits of the transmission channel.

10. The apparatus according to claim 7, wherein when the i ^{th} group comprises P coded bits, wherein *i*=1,2,···,*M*, *t*=0,1,···,*P*-1, and *P* = *N* / *M*, *N* is a positive integer, and *N* represents a length of a coded bit output by the Polar encoder, the first rate matching module is specifically configured to: sequentially output coded bits, on which the interleaving processing is performed, in the 1^{st} group to the W^{th} group to the virtual IR buffer module, and output the 1^{st} to the *N*_{*RM*1} - *WP*^{th} coded bits, on which the interleaving processing is performed, in the (W+1)^{th} group to the virtual IR buffer module, wherein W meets *WP*<*N*_{*RM*1} ≤ (*W*+1)*P*, *N*_{*RM*1} =min(*N*,*N_{IR}*), and *N_{IR}* represents the size of the virtual IR buffer module.

11. The apparatus according to claim 10, wherein the second rate matching module comprises:
a bit reduction processing unit, configured to: when *N_{data}* ≤ *N*_{*RM*1}, starting from the S2^{th} group, corresponding to a preconfigured second start position, in the virtual IR buffer module, sequentially output coded bits, on which the interleaving processing is performed, in V groups, and output the 1^{st} to the *N_{data}*-*VP*ₜₕ coded bits, on which interleaving coding processing is performed, in a next group after the V groups, wherein V meets *VP*<*N_{data} ≤*(*V*+1)*P*; and *N_{data}* represents the quantity of available bits of the transmission channel; and
a bit repetition processing unit, configured to: when *N_{data}* > *N*_{*RM*1}, starting from the S2^{th} group, sequentially and cyclically output coded bits, on which the interleaving processing is performed, in W+1 groups, wherein a quantity of cycles is *W*'; and then starting from the S2^{th} group again, sequentially output the 1^{st} to the *N_{data}* - *W*' *N*_{*RM*1^{th}} coded bits, on which the interleaving processing is performed, in each group of the *V*'+ 1 groups; wherein *W*' meets *W'P<N_{data}*≤(*W'*+1)*N*_{*RM*1}, *V*' meets *V'P*<*N_{data} -W'NN*_{*RM*1} ≤(*V'*+1)*P*, and *N_{data}* represents the quantity of available bits of the transmission channel.

## Patentansprüche

1. Verfahren zur Codierungsratenanpassungsverarbeitung, umfassend:
Aufteilen (101) der Ausgabe codierter Bits mittels eines Polar-Encoders auf *M* Gruppen und Durchführen von verschachtelter Verarbeitung, separat an codierten Bits in der 1. Gruppe bis zur *M*-ten Gruppe, wobei *M* eine positive Ganzzahl ist;
wobei das Verfahren **gekennzeichnet ist durch**
Durchführen (102) von Bit-Reduktionsverarbeitung an codierten Bits, die verschachtelter Verarbeitung unterzogen worden sind, in mehreren Gruppen der *M* Gruppen entsprechend einer Größe eines virtuellen IR-Puffermoduls; Ausgeben der codierten Bits in ersten Gruppen von der 1. Gruppe bis zur M-ten Gruppe zu dem virtuellen IR-Puffermodul, wobei Bit-Reduktionsverarbeitung über das Verwerfen codierter Bits in letzten Gruppen der 1. Gruppe bis zur *M*-ten Gruppe erfolgt;
Vergleichen (103) einer Menge verfügbarer Bits eines Übertragungskanals mit einer Menge codierter Bits in mehreren Gruppen, die in dem virtuellen IR-Puffermodul gespeichert sind, und, entsprechend einem Vergleichsergebnis, Durchführen von Wiederholungs- oder Reduktionsverarbeitung an den codierten Bits in den mehreren Gruppen, die in dem virtuellen IR-Puffermodul gespeichert sind; und
Durchführen (104) von Verkettungsverarbeitung an codierten Bits nach der Durchführung von Wiederholungs- oder Reduktionsverarbeitung, um einen Bitstream zu erzeugen und den Bitstream durch den Übertragungskanal zu senden.

2. Verfahren nach Anspruch 1, wobei, wenn die i-te Gruppe P codierte Bits umfasst, *j=(i-1) P* + *t,* wobei *i =1, 2,* ···, *M, t* = *0,1,··*·, *P-1* und *P* = *N* / *M*, *N* eine positive Ganzzahl ist und *N* eine Länge einer Ausgabe codierter Bits durch den Polar-Encoder darstellt, sowie das Durchführen von Bit-Reduktionsverarbeitung an codierten Bits in mehreren Gruppen der *M* Gruppen entsprechend einer Größe eines virtuellen IR-Puffermoduls; das Codieren von Bits, an denen die Reduktionsverarbeitung durchgeführt wird, in ersten Gruppen von der 1. Gruppe bis zur M-ten Gruppe; das Ausgeben der codierten Bits zu einem virtuellen IR-Puffermodul; und das Verwerfen codierter Bits in letzten Gruppen von der 1. Gruppe bis zur *M*-ten Gruppe umfassen: Beginnend ab der 1. Gruppe, sequenzielles Ausgeben codierter Bits, an denen die verschachtelte Verarbeitung durchgeführt wird, in jeder Gruppe zu dem virtuellen IR-Puffermodul, bis *N_{RM1}* codierte Bits, an denen die verschachtelte Verarbeitung durchgeführt wird, ausgegeben sind, wobei *N_{RM1}* = min *(N,N_{IR})* und *N_{IR}* die Größe des virtuellen IR-Puffermoduls wiedergibt.

3. Verfahren nach Anspruch 2, wobei das Vergleichen einer Menge verfügbarer Bits eines Übertragungskanals mit einer Menge von codierten Bits in mehreren Gruppen, gespeichert in dem virtuellen IR-Puffermodul, und das Durchführen, entsprechend einem Vergleichsergebnis, von Wiederholungs- oder Reduktionsverarbeitung an den codierten Bits in den mehreren Gruppen, die in dem virtuellen IR-Puffermodul gespeichert sind, umfasst:
wenn *N_{data}*≤*N_{RM1}*, beginnend ab der S1-ten Gruppe, entsprechend einer vorkonfigurierten ersten Startposition im virtuellen IR-Puffermodul, sequenzielles Ausgeben der codierten Bits von jeder Gruppe, an denen die verschachtelte Verarbeitung durchgeführt wird, bis *N_{data}* codierte Bits, an denen die verschachtelte Verarbeitung durchgeführt wird, ausgegeben sind; und
wenn *N_{data}*>*N_{RM1}*, beginnend ab der S1-ten Gruppe und mit sequenziellem und zyklischem Beginn der Ausgabe der codierten Bits aus jeder Gruppe, an denen die verschachtelte Verarbeitung durchgeführt wird, bis die *N_{data}* codierten Bits, an denen die verschachtelte Verarbeitung durchgeführt wird, ausgegeben sind, wobei *N_{data}* die Menge verfügbarer Bits des Übertragungskanals darstellt.

4. Verfahren nach Anspruch 1, wobei, wenn die i-te Gruppe P codierte Bits umfasst, *j=(i-1) P* + *t,* wobei *i =1, 2,* ···, *M, t* = *0,1,··*·, *P-1* und *P* = *N* / *M*, *N* eine positive Ganzzahl ist und *N* eine Länge einer Ausgabe codierter Bits durch den Polar-Encoder darstellt, sowie das Durchführen von Bit-Reduktionsverarbeitung an codierten Bits in mehreren Gruppen der *M* Gruppen entsprechend einer Größe eines virtuellen IR-Puffermoduls; das Codieren von Bits, an denen die Reduktionsverarbeitung durchgeführt wird, in ersten Gruppen von der 1. Gruppe bis zur M-ten Gruppe; das Ausgeben der codierten Bits zu einem virtuellen IR-Puffermodul und das Verwerfen codierter Bits in letzten Gruppen von der 1. Gruppe bis zur *M*-ten Gruppe umfassen: sequenzielles Ausgeben codierter Bits, an denen die verschachtelte Verarbeitung durchgeführt wird, in der 1. Gruppe bis zur W-ten Gruppe zu dem virtuellen IR-Puffermodul, und Ausgeben der 1. bis *N_{RM1}-WP*-ten codierten Bits, an denen die verschachtelte Verarbeitung durchgeführt wird, in der (W+1)-ten Gruppe zu dem virtuellen IR-Puffermodul, wobei W der Bedingung *WP*<*N_{RM1}≤(W+1)P, N_{RM1}* = min *(N,N_{IR})* genügt und *N_{IR}* die Größe des virtuellen IR-Puffermoduls wiedergibt.

5. Verfahren nach Anspruch 4, wobei das Vergleichen einer Menge verfügbarer Bits eines Übertragungskanals mit einer Menge codierter Bits in mehreren Gruppen, die in dem virtuellen IR-Puffermodul gespeichert sind, und das Durchführen, entsprechend einem Vergleichsergebnis, von Wiederholungs- oder Reduktionsverarbeitung an den codierten Bits in den mehreren Gruppen, die in dem virtuellen IR-Puffermodul gespeichert sind, umfasst:
wenn *N_{data}*≤*N_{RM1}*, beginnend ab der S2-ten Gruppe, entsprechend einer vorkonfigurierten ersten Startposition im virtuellen IR-Puffermodul, sequenzielles Ausgeben codierter Bits, an denen die verschachtelte Verarbeitung durchgeführt wird, in V Gruppen und Ausgeben der 1. bis *N_{data}-VP-*ten codierten Bits, an denen die verschachtelte Codierverarbeitung durchgeführt wird, in eine nächste Gruppe nach den V Gruppen, wobei V der Bedingung *VP*<*N_{data}*≤*(V+1)P* genügt und *N_{data}* die Menge verfügbarer Bits des Übertragungskanals wiedergibt; und
wenn *N_{data}*>*N_{RM1}*, beginnend ab der S2-ten Gruppe und mit sequenzieller und zyklischer Ausgabe codierter Bits aus jeder Gruppe, an denen die verschachtelte Verarbeitung durchgeführt wird, in W+1 Gruppen, wobei eine Menge von Zyklen *W'* ist; und anschließend erneuter Beginn ab der S2-ten Gruppe mit sequenzieller Ausgabe der 1. bis *N_{data}-W'N_{RM1}*-ten codierten Bits, an denen die verschachtelte Verarbeitung durchgeführt wird, in jeder Gruppe von *V*'+1 Gruppen, wobei *W'* der Bedingung *W'P*<*N_{data}*≤*(W'*+*1)N_{RM1}* genügt, *V*' der Bedingung *V'P*<*N_{data}-W'NN_{RM1}*≤*(V'*+*1)P* genügt und *N_{data}* die Menge verfügbarer Bits des Übertragungskanals wiedergibt.

6. Verfahren nach Anspruch 1, wobei das Vergleichen einer Menge verfügbarer Bits eines Übertragungskanals mit einer Menge von codierten Bits in mehreren Gruppen, gespeichert in dem virtuellen IR-Puffermodul, und das Durchführen, entsprechend einem Vergleichsergebnis, von Wiederholungs- oder Reduktionsverarbeitung an den codierten Bits in den mehreren Gruppen, die in dem virtuellen IR-Puffermodul gespeichert sind, umfasst:
wenn *N_{data}*≤*N_{RM1}*, Ausgeben der Systembits, an denen die verschachtelte Verarbeitung durchgeführt wird, in der 1. Gruppe aus dem virtuellen IR-Puffermodul; und beginnend ab der S3-ten Gruppe, entsprechend einer vorkonfigurierten dritten Startposition in dem virtuellen IR-Puffermodul, sequenzielles Ausgeben von Paritätsbits, an denen die verschachtelte Verarbeitung durchgeführt wird, in V Gruppen und Ausgeben der 1. bis *N_{data}-K-VP-*ten codierten Bits, an denen verschachtelte Codierungsverarbeitung durchgeführt wird, in eine nächste Gruppe nach den V Gruppen, wobei V der Bedingung *VP*<*N_{data}-K≤(V+1)P* genügt, und *N_{data}* die Menge verfügbarer Bits des Übertragungskanals wiedergibt; und
wenn *N_{data}*>*N_{RM1}*, *W'*-maliges zyklisches Ausgeben der Systembits aus dem virtuellen IR-Puffermodul, an denen die verschachtelte Verarbeitung durchgeführt wird, in die 1. Gruppe; und beginnend ab der S3-ten Gruppe in dem virtuellen IR-Puffermodul, sequenzielles und zyklisches Ausgeben von Paritätsbits, an denen die verschachtelte Verarbeitung durchgeführt wird, in W'+1 Gruppen, wobei eine Menge von Zyklen W' ist; anschließend Ausgeben der Systembits, an denen die verschachtelte Verarbeitung durchgeführt wird, in die 1. Gruppe, und, beginnend mit der S3-ten Gruppe, sequenzielles Ausgeben von Paritätsbits, an denen die verschachtelte Verarbeitung durchgeführt wird, in *V*' Gruppen, und schließlich Ausgeben der 1. bis *N_{data}-W'N_{RM1}*-*V*'*P*-ten Paritätsbits in eine nächste Gruppe nach den *V'* Gruppen, wobei *W'* der Bedingung *W'P*<*N_{data}*≤*(W'*+*1)N_{RM1}* genügt, *V'* der Bedingung *V'P*<*N_{data}*-*W'NN_{RM1}*≤*(V'*+*1)P* genügt und *N_{data}* die Menge verfügbarer Bits des Übertragungskanals wiedergibt.

7. Vorrichtung zur Codierungsratenanpassungsverarbeitung, umfassend:
ein Teilungsmodul (11), ausgelegt zum Aufteilen der Ausgabe codierter Bits mittels eines Polar-Encoders auf *M* Gruppen, wobei *M* eine positive Ganzzahl ist;
ein Verschachtelungsverarbeitungsmodul (12), ausgelegt zum Durchführen von separater verschachtelter Verarbeitung an codierten Bits in der 1. Gruppe bis zur *M-*ten Gruppe;
wobei die Vorrichtung **gekennzeichnet ist durch**
ein erstes Ratenanpassungsmodul (13), ausgelegt zum Durchführen von Bit-Reduktionsverarbeitung an codierten Bits, die verschachtelte Verarbeitung in mehreren Gruppen der *M* Gruppen entsprechend einer Größe eines virtuellen IR-Puffermoduls (14) durchlaufen haben; Ausgeben der codierten Bits in erste Gruppen der 1. Gruppe bis *M*-ten Gruppe zu dem virtuellen IR-Puffermodul, wobei die Bitreduktionsverarbeitung durch das Verwerfen codierter Bits in letzten Gruppen der 1. Gruppe bis *M*-ten Gruppe erfolgt;
das IR-Puffermodul, ausgelegt zum Speichern codierter Bits in mehreren Gruppen, ausgegeben durch das erste Ratenanpassungsmodul;
ein zweites Ratenanpassungsmodul (15), ausgelegt zum Vergleichen einer Menge verfügbarer Bits eines Übertragungskanals mit einer Menge codierter Bits in mehreren Gruppen, die in dem virtuellen IR-Puffermodul gespeichert sind, und, entsprechend einem Vergleichsergebnis, Durchführen von Wiederholungs- oder Reduktionsverarbeitung an den codierten Bits in den mehreren Gruppen, die in dem virtuellen IR-Puffermodul gespeichert sind; und
ein Erfassungsmodul (16) für codierte Bits, ausgelegt zum Durchführen von Verkettungsverarbeitung an codierten Bits nach der Durchführung von Wiederholungs- oder Reduktionsverarbeitung, um einen Bitstream zu erzeugen.

8. Vorrichtung nach Anspruch 7, wobei, wenn die i-te Gruppe P codierte Bits umfasst, *j=(i-1) P* + *t,* wobei *i =1, 2,* ···, *M, t* = *0,1,··*·, *P-1* und *P* = *N* / *M*, *N* eine positive Ganzzahl ist und *N* eine Länge einer Ausgabe codierter Bits durch den Polar-Encoder darstellt, das erste Ratenanpassungsmodul im Einzelnen dafür ausgelegt ist, beginnend ab der 1. Gruppe in jeder Gruppe codierte Bits, an denen die verschachtelte Verarbeitung durchgeführt wird, sequenziell zu dem virtuellen IR-Puffermodul auszugeben, bis *N_{RM1}* codierte Bits, an denen die verschachtelte Verarbeitung durchgeführt wird, ausgegeben sind, wobei *N_{RM1}* = min *(N,N_{IR})* und *N_{IR}* die Größe des virtuellen IR-Puffermoduls wiedergibt.

9. Vorrichtung nach Anspruch 8, wobei das zweite Ratenanpassungsmodul umfasst:
eine Bit-Reduktionsverarbeitungseinheit, dafür ausgelegt, wenn *N_{data}*≤*N_{RM1}*, beginnend ab der S1-ten Gruppe entsprechend einer vorkonfigurierten ersten Startposition in dem virtuellen IR-Puffermodul aus jeder Gruppe sequenziell die codierten Bits auszugeben, an denen die verschachtelte Verarbeitung durchgeführt wird, bis *N_{data}* codierte Bits, an denen die verschachtelte Verarbeitung durchgeführt wird, ausgegeben sind; und
eine Bit-Wiederholungsverarbeitungseinheit, dafür ausgelegt, wenn *N_{data}*>*N_{RM1}*, ab der S1-ten Gruppe zu beginnen, aus jeder Gruppe sequenziell und zyklisch die codierten Bits auszugeben, an denen die verschachtelte Verarbeitung durchgeführt wird, bis die *N_{data}* codierten Bits, an denen die verschachtelte Verarbeitung durchgeführt wird, ausgegeben sind; wobei *N_{data}* die Menge verfügbarer Bits des Übertragungskanals wiedergibt.

10. Vorrichtung nach Anspruch 7, wobei, wenn die i-te Gruppe P codierte Bits umfasst, wobei *i =1, 2,* ···, *M, t* = *0,1,··*·, *P-1* und *P* = *N*/*M*, *N* eine positive Ganzzahl ist und *N* eine Länge einer Ausgabe codierter Bits durch den Polar-Encoder darstellt, das erste Ratenanpassungsmodul im Einzelnen ausgelegt ist zum sequenziellen Ausgeben codierter Bits, an denen die verschachtelte Verarbeitung durchgeführt wird, in der 1. Gruppe bis zur W-ten Gruppe zu dem virtuellen IR-Puffermodul, und Ausgeben der 1. bis *N_{RM1}-WP-*ten codierten Bits, an denen die verschachtelte Verarbeitung durchgeführt wird, in der (W+1)-ten Gruppe zu dem virtuellen IR-Puffermodul, wobei W der Bedingung *WP*<*N_{RM1}*≤*(W*+ *1)P*, *N_{RM1}* = min (*N*,*N_{IR}*) genügt und *N_{IR}* die Größe des virtuellen IR-Puffermoduls wiedergibt.

11. Vorrichtung nach Anspruch 10, wobei das zweite Ratenanpassungsmodul umfasst:
eine Bit-Reduktionsverarbeitungseinheit, dafür ausgelegt, wenn *N_{data}*≤*N_{RM1}*, beginnend ab der S2-ten Gruppe, entsprechend einer vorkonfigurierten zweiten Startposition im virtuellen IR-Puffermodul, codierte Bits, an denen die verschachtelte Verarbeitung durchgeführt wird, in V Gruppen sequenziell auszugeben und die 1. bis *N_{data}-VP-*ten codierten Bits, an denen verschachtelte Codierverarbeitung durchgeführt wird, in eine nächste Gruppe nach den V Gruppen auszugeben, wobei V der Bedingung *VP*<*N_{data}*≤*(V*+*1)P* genügt und *N_{data}* die Menge verfügbarer Bits des Übertragungskanals wiedergibt; und
eine Bit-Wiederholungsverarbeitungseinheit, dafür ausgelegt, wenn *N_{data}*>*N_{RM1}*, beginnend ab der S2-ten Gruppe codierte Bits, an denen die verschachtelte Verarbeitung durchgeführt wird, in W+1 Gruppen sequenziell und zyklisch auszugeben, wobei eine Menge von Zyklen *W'* ist; und anschließend ab der S2-ten Gruppe die 1. bis *N_{data}-W'N_{RM1}*-ten codierten Bits, an denen die verschachtelte Verarbeitung durchgeführt wird, in jeder Gruppe der *V'*+1 Gruppen erneut sequenziell auszugeben, wobei *W'* der Bedingung *W'P*<*N_{data}*≤*(W'*+*1)N_{RM1}* genügt, *V'* der Bedingung *V'P*<*N_{data}-W'NN_{RM1}*≤*(V'*+*1)P* genügt und *N_{data}* die Menge verfügbarer Bits des Übertragungskanals wiedergibt.

## Revendications

1. Procédé de traitement d'adaptation de débit pour du codage, comprenant :
la division (101) de bits codés délivrés par un codeur polaire en *M* groupes, et la réalisation d'un traitement d'entrelacement sur des bits codés dans le 1^{er} groupe jusqu'au *M*^{ième} groupe séparément, où *M* est un entier positif ;
le procédé étant **caractérisé par** :
la réalisation (102) d'un traitement de réduction de bits sur des bits codés ayant subi un traitement d'entrelacement dans de multiples groupes parmi les *M* groupes en fonction d'une taille d'un module tampon de redondance incrémentale, IR, virtuel, et
la délivrance des bits codés dans des premiers groupes parmi le 1^{er} groupe jusqu'au *M*^{ième} groupe au module tampon IR virtuel, le traitement de réduction de bits se faisant en rejetant des bits codés dans des derniers groupes parmi le 1^{er} groupe jusqu'au *M*^{ième} groupe ;
la comparaison (103) d'une quantité de bits disponibles d'une voie de transmission avec une quantité de bits codés, dans de multiples groupes, stockés dans le module tampon IR virtuel, et la réalisation, en fonction d'un résultat de comparaison, d'un traitement de répétition ou de réduction sur les bits codés, dans les multiples groupes, stockés dans le module tampon IR virtuel ; et
la réalisation (104) d'un traitement de concaténation sur des bits codés après que le traitement de répétition ou de réduction a été effectué, pour générer un train de bits, et l'envoi du train de bits à travers la voie de transmission.

2. Procédé selon la revendication 1 dans lequel, quand le *i*^{ième} groupe comprend P bits codés, *j* = (*i*-1)*P*+*t*, où *i* = 1, 2, ..., *M*, *t* = 0, 1, ..., *P*-1, et *P* = *N*/*M*, *N* est un entier positif, et *N* représente une longueur d'un bit codé délivré par le codeur polaire, la réalisation d'un traitement de réduction de bits sur des bits codés dans de multiples groupes parmi les *M* groupes en fonction d'une taille d'un module tampon IR virtuel, le codage de bits, sur lesquels le traitement de réduction est effectué, dans des premiers groupes parmi le 1^{er} groupe jusqu'au *M*^{ième} groupe, la délivrance des bits codés au module tampon IR virtuel, et le rejet de bits codés dans des derniers groupes parmi le 1^{er} groupe jusqu'au *M*^{ième} groupe comprennent :
en partant du 1^{er} groupe, la délivrance séquentielle de bits codés, sur lesquels le traitement d'entrelacement est effectué, dans chaque groupe au module tampon IR virtuel, jusqu'à ce que *N*_{*RM*1} bits codés sur lesquels le traitement d'entrelacement est effectué soient délivrés, où *N*_{*RM*1} = min(*N*, *N_{IR}),* et *N_{IR}* représente la taille du module tampon IR virtuel.

3. Procédé selon la revendication 2, dans lequel la comparaison d'une quantité de bits disponibles d'une voie de transmission avec une quantité de bits codés, dans de multiples groupes, stockés dans le module tampon IR virtuel, et la réalisation, en fonction d'un résultat de comparaison, d'un traitement de répétition ou de réduction sur les bits codés, dans les multiples groupes, stockés dans le module tampon IR virtuel comprennent :
quand *N_{data}* ≤ *N*_{*RM*1}, en partant du S1^{ième} groupe, correspondant à une première position de départ préconfigurée, dans le module tampon IR virtuel, la délivrance séquentielle, depuis chaque groupe, des bits codés sur lesquels le traitement d'entrelacement est effectué, jusqu'à ce que *N_{data}* bits codés sur lesquels le traitement d'entrelacement est effectué soient délivrés ; et
quand *N_{data} > N*_{*RM*1}, en partant du S1^{ième} groupe, le lancement séquentiel et cyclique de la délivrance, depuis chaque groupe, des bits codés sur lesquels le traitement d'entrelacement est effectué, jusqu'à ce que les *N_{data}* bits codés sur lesquels le traitement d'entrelacement est effectué soient délivrés, où *N_{data}* représente la quantité de bits disponibles de la voie de transmission.

4. Procédé selon la revendication 1 dans lequel, quand le *i*^{ième} groupe comprend P bits codés, *j* = (*i*-1)*P*+*t*, où *i* = 1, 2, ..., *M*, *t* = 0, 1, ..., *P*-1, et *P* = *N*/*M*, *N* est un entier positif, et *N* représente une longueur d'un bit codé délivré par le codeur polaire, la réalisation d'un traitement de réduction de bits sur des bits codés dans de multiples groupes parmi les *M* groupes en fonction d'une taille d'un module tampon IR virtuel, le codage de bits, sur lesquels le traitement de réduction est effectué, dans des premiers groupes parmi le 1^{er} groupe jusqu'au *M*^{ième} groupe, la délivrance des bits codés au module tampon IR virtuel, et le rejet de bits codés dans des derniers groupes parmi le 1^{er} groupe jusqu'au *M*^{ième} groupe comprennent :
la délivrance séquentielle de bits codés, sur lesquels le traitement d'entrelacement est effectué, dans le 1^{er} groupe jusqu'au *W*^{*iè*me} groupe au module tampon IR virtuel, et la délivrance des 1^{er} jusqu'au (*N*_{*RM*1}*-WP*)*^{ième}* bits codés, sur lesquels le traitement d'entrelacement est effectué, dans le (*W*+1)^{ième} groupe au module tampon IR virtuel, où *W* respecte *WP < N*_{*RM*1} ≤ (*W*+1)*P*, *N*_{*RM*1} = min(*N*, *N_{IR}),* et *N_{IR}* représente la taille du module tampon IR virtuel.

5. Procédé selon la revendication 4, dans lequel la comparaison d'une quantité de bits disponibles d'une voie de transmission avec une quantité de bits codés, dans de multiples groupes, stockés dans le module tampon IR virtuel, et la réalisation, en fonction d'un résultat de comparaison, d'un traitement de répétition ou de réduction sur les bits codés, dans les multiples groupes, stockés dans le module tampon IR virtuel comprennent :
quand *N_{data}* ≤ *N*_{*RM*1}*,* en partant du S2^{ième} groupe, correspondant à une deuxième position de départ préconfigurée, dans le module tampon IR virtuel, la délivrance séquentielle de bits codés, sur lesquels le traitement d'entrelacement est effectué, dans *V* groupes, et la délivrance des 1^{er} jusqu'au (*N_{data}-VP*)^{ième} bits codés, sur lesquels le traitement de codage par entrelacement est effectué, dans un groupe suivant après les *V* groupes, où *V* respecte *VP < N_{data}* ≤ (*V*+1)*P,* et *N_{data}* représente la quantité de bits disponibles de la voie de transmission ; et
quand *N_{data} > N*_{*RM*1}*,* en partant du S2^{ième} groupe, la délivrance séquentielle et cyclique de bits codés, sur lesquels le traitement d'entrelacement est effectué, dans *W*+1 groupes, une quantité de cycles étant *W*' ; puis, de nouveau en partant du S2^{ième} groupe, la délivrance séquentielle des 1^{er} jusqu'au (*N_{data}-W'N*_{*RM*1})^{ième} bits codés, sur lesquels le traitement d'entrelacement est effectué, dans chaque groupe parmi *V*'+1 groupes, où *W'* respecte *W'P < N_{data}* ≤ (*W'*+1)*N*_{*RM*1}*, V'* respecte *V'P < N_{data}-W'NN*_{*RM*1} ≤ (*V'*+1)*P,* et *N_{data}* représente la quantité de bits disponibles de la voie de transmission.

6. Procédé selon la revendication 1, dans lequel la comparaison d'une quantité de bits disponibles d'une voie de transmission avec une quantité de bits codés, dans de multiples groupes, stockés dans le module tampon IR virtuel, et la réalisation, en fonction d'un résultat de comparaison, d'un traitement de répétition ou de réduction sur les bits codés, dans les multiples groupes, stockés dans le module tampon IR virtuel comprennent :
quand *N_{data}* ≤ *N*_{*RM*1}*,* la délivrance, depuis le module tampon IR virtuel, des bits de système, sur lesquels le traitement d'entrelacement est effectué, dans le 1^{er} groupe ; et en partant du S3^{ième} groupe, correspondant à une troisième position de départ préconfigurée, dans le module tampon IR virtuel, la délivrance séquentielle de bits de parité, sur lesquels le traitement d'entrelacement est effectué, dans V groupes, et la délivrance des 1^{er} jusqu'au (*N_{data}-K-VP*)^{ième} bits codés, sur lesquels le traitement d'entrelacement est effectué, dans un groupe suivant après les V groupes, où *V* respecte *VP* < *N_{data}-K* ≤ (*V*+1)*P,* et *N_{data}* représente la quantité de bits disponibles de la voie de transmission ; et
quand *N_{data} > N*_{*RM*1}*,* la délivrance cyclique, depuis le module tampon IR virtuel, *W'* fois, des bits de système, sur lesquels le traitement d'entrelacement est effectué, dans le 1^{er} groupe, et en partant du S3^{ième} groupe dans le module tampon IR virtuel, la délivrance séquentielle et cyclique de bits de parité, sur lesquels le traitement d'entrelacement est effectué, dans *W*'+1 groupes, une quantité de cycles étant *W*' ; puis la délivrance des bits de système, sur lesquels le traitement d'entrelacement est effectué, dans le 1^{er} groupe, et en partant du S3^{ième} groupe, la délivrance séquentielle de bits de parité, sur lesquels le traitement d'entrelacement est effectué, dans *V*' groupes ; et enfin, la délivrance des 1^{er} jusqu'au (*N_{data}-W'N*_{*RM*1}*-V'P*)^{ième} bits de parité dans un groupe suivant après les *V*' groupes, où *W'* respecte *W'P < N_{data}* ≤ (*W'*+1)*N*_{*RM*1}*, V'* respecte *V'P* < *N_{data}-W'NN*_{*RM*1} ≤ (*V'*+1)*P,* et *N_{data}* représente la quantité de bits disponibles de la voie de transmission.

7. Appareil de traitement d'adaptation de débit pour du codage, comprenant :
un module de division (11), configuré pour diviser des bits codés délivrés par un codeur polaire en *M* groupes, où *M* est un entier positif ;
un module de traitement d'entrelacement (12), configuré pour réaliser un traitement d'entrelacement sur des bits codés dans le 1^{er} groupe jusqu'au *M*^{ième} groupe séparément ;
l'appareil étant **caractérisé par** :
un premier module d'adaptation de débit (13), configuré pour réaliser un traitement de réduction de bits sur des bits codés ayant subi un traitement d'entrelacement dans de multiples groupes parmi les *M* groupes en fonction d'une taille d'un module tampon de redondance incrémentale, IR, virtuel (14), et délivrer les bits codés dans des premiers groupes parmi le 1^{er} groupe jusqu'au *M*^{ième} groupe au module tampon IR virtuel, le traitement de réduction de bits se faisant en rejetant des bits codés dans des derniers groupes parmi le 1^{er} groupe jusqu'au *M*^{ième} groupe ;
le module tampon IR virtuel, configuré pour stocker des bits codés, dans de multiples groupes, délivrés par le premier module d'adaptation de débit ;
un deuxième module d'adaptation de débit (15), configuré pour comparer une quantité de bits disponibles d'une voie de transmission avec une quantité de bits codés, dans de multiples groupes, stockés dans le module tampon IR virtuel, et réaliser, en fonction d'un résultat de comparaison, un traitement de répétition ou de réduction sur les bits codés, dans les multiples groupes, stockés dans le module tampon IR virtuel ; et
un module de collecte de bits codés (16), configuré pour réaliser un traitement de concaténation sur des bits codés après que le traitement de répétition ou de réduction a été effectué, pour générer un train de bits.

8. Appareil selon la revendication 7 dans lequel, quand le *i*^{ième} groupe comprend P bits codés, *j* = (*i*-1)*P*+*t,* où *i* = 1, 2, ..., *M, t* = 0, 1, ..., *P-*1*,* et *P* = *N*/*M, N* est un entier positif, et *N* représente une longueur d'un bit codé délivré par le codeur polaire, le premier module d'adaptation de débit est spécifiquement configuré pour : en partant du 1^{er} groupe, délivrer séquentiellement des bits codés, sur lesquels le traitement d'entrelacement est effectué, dans chaque groupe au module tampon IR virtuel, jusqu'à ce que *N*_{*RM*1} bits codés sur lesquels le traitement d'entrelacement est effectué soient délivrés, où *N*_{*RM*1} = min(*N*, *N_{IR}),* et *N_{IR}* représente la taille du module tampon IR virtuel.

9. Appareil selon la revendication 8, dans lequel le deuxième module d'adaptation de débit comprend :
une unité de traitement de réduction de bits, configurée pour : quand *N_{data}* ≤ *N*_{*RM*1}*,* en partant du S1^{ième} groupe, correspondant à une première position de départ préconfigurée, dans le module tampon IR virtuel, délivrer séquentiellement, depuis chaque groupe, les bits codés sur lesquels le traitement d'entrelacement est effectué, jusqu'à ce que *N_{data}* bits codés sur lesquels le traitement d'entrelacement est effectué soient délivrés ; et
une unité de traitement de répétition de bits, configurée pour : quand *N_{data} > N*_{*RM*1}*,* en partant du S1^{ième} groupe, commencer séquentiellement et cycliquement à délivrer, depuis chaque groupe, les bits codés sur lesquels le traitement d'entrelacement est effectué, jusqu'à ce que les *N_{data}* bits codés sur lesquels le traitement d'entrelacement est effectué soient délivrés, où *N_{data}* représente la quantité de bits disponibles de la voie de transmission.

10. Appareil selon la revendication 7 dans lequel, quand le *i*^{ième} groupe comprend *P* bits codés, où *i* = 1, 2, ..., *M, t* = 0, 1, ..., *P-*1*,* et *P* = *N*/*M, N* est un entier positif, et *N* représente une longueur d'un bit codé délivré par le codeur polaire, le premier module d'adaptation de débit est spécifiquement configuré pour : délivrer séquentiellement des bits codés, sur lesquels le traitement d'entrelacement est effectué, dans le 1^{er} groupe jusqu'au *W*^{ième} groupe au module tampon IR virtuel, et délivrer les 1^{er} jusqu'au (*N*_{*RM*1}*-WP*)^{ième} bits codés, sur lesquels le traitement d'entrelacement est effectué, dans le (*W*+1)^{ième} groupe au module tampon IR virtuel, où *W* respecte *WP < N*_{*RM*1} ≤ (*W*+1)*P, N*_{*RM*1} = min(*N*, *N_{IR}*)*,* et *N_{IR}* représente la taille du module tampon IR virtuel.

11. Appareil selon la revendication 10, dans lequel le deuxième module d'adaptation de débit comprend :
une unité de traitement de réduction de bits, configurée pour : quand *N_{data}* ≤ *N*_{*RM*1}*,* en partant du S2^{ième} groupe, correspondant à une deuxième position de départ préconfigurée, dans le module tampon IR virtuel, délivrer séquentiellement des bits codés, sur lesquels le traitement d'entrelacement est effectué, dans *V* groupes, et délivrer les 1^{er} jusqu'au (*N_{data}-VP*)^{ième} bits codés, sur lesquels le traitement de codage par entrelacement est effectué, dans un groupe suivant après les *V* groupes, où *V* respecte *VP* < *N_{data}* ≤ (*V*+1)*P,* et *N_{data}* représente la quantité de bits disponibles de la voie de transmission ; et
une unité de traitement de répétition de bits, configurée pour : quand *N_{data} > N*_{*RM*1}*,* en partant du S2^{ième} groupe, délivrer séquentiellement et cycliquement des bits codés, sur lesquels le traitement d'entrelacement est effectué, dans *W*+1 groupes, une quantité de cycles étant *W*' ; puis, de nouveau en partant du S2^{ième} groupe, délivrer séquentiellement les 1^{er} jusqu'au (*N_{data}-W'N*_{*RM*1})*^{ième}* bits codés, sur lesquels le traitement d'entrelacement est effectué, dans chaque groupe parmi les *V*'+1 groupes, où *W'* respecte *W'P < N_{data}* ≤ (*W'*+1)*N*_{*RM*1}*, V'* respecte *V'P* < *N_{data}-W'NN*_{*RM*1} ≤ (*V'*+1)*P,* et *N_{data}* représente la quantité de bits disponibles de la voie de transmission.
